# EUROPEAN PATENT APPLICATION

(11) **EP 2 234 163 A1**
(43) Date of publication of application: **29.09.2010**
(21) Application number: 08859002.1
(22) Date of filing: 02.12.2008
(51) Int. Cl.: H01L 29/739, H01L 21/336, H01L 29/12, H01L 29/78

(54) **SEMICONDUCTOR DEVICE AND METHOD OF MANUFACTURING THE DEVICE, AND METHOD OF MANUFACTURING TRENCH GATE**

(30) Priority: 10.12.2007 JP 2007317913; 16.06.2008 JP 2008156240
(71) Applicant: Toyota Jidosha Kabushiki Kaisha, Toyota-shi, Aichi-ken 471-71 (JP)
(72) Inventor: AOI, Sachiko, Aichi-gun Aichi 480-1192 (JP); SUGIYAMA, Takahide, Aichi-gun Aichi 480-1192 (JP); SUZUKI, Takashi, Aichi-gun Aichi 480-1192 (JP); SOENO, Akitaka, Toyota-shi Aichi 471-8571 (JP); NISHIWAKI, Tsuyoshi, Toyota-shi Aichi 471-8571 (JP)
(74) Representative: TBK-Patent
(86) International application number: PCT/JP2008/071858
(87) International publication number: WO 2009/075200

(57) **Abstract**

IGBT 10 comprises an n⁺-type emitter region 34, an n⁻-type drift region 26, a p-type body region 28 disposed between the emitter region 34 and the drift region 26, a trench gate 40 extending in the body region 28 from the emitter region 34 toward the drift region 26, and a projecting portion 60 of an insulating material being in contact with a surface of the trench gate 40. At least a part of the projecting portion 60 projects within the drift region 26.

## Description

### Field of the Invention

The present application claims priorities to Japanese Patent Application No. 2007-317913 filed on December 10, 2007 and Japanese Patent Application No. 2008-156240 filed on June 16, 2008, the contents of which are hereby incorporated by reference into the present specification.
The present invention relates to a semiconductor device with a trench gate and a manufacuturing method thereof. The present invention also relates to a manufacuturing method of the trench gate.

### Background of the Invention

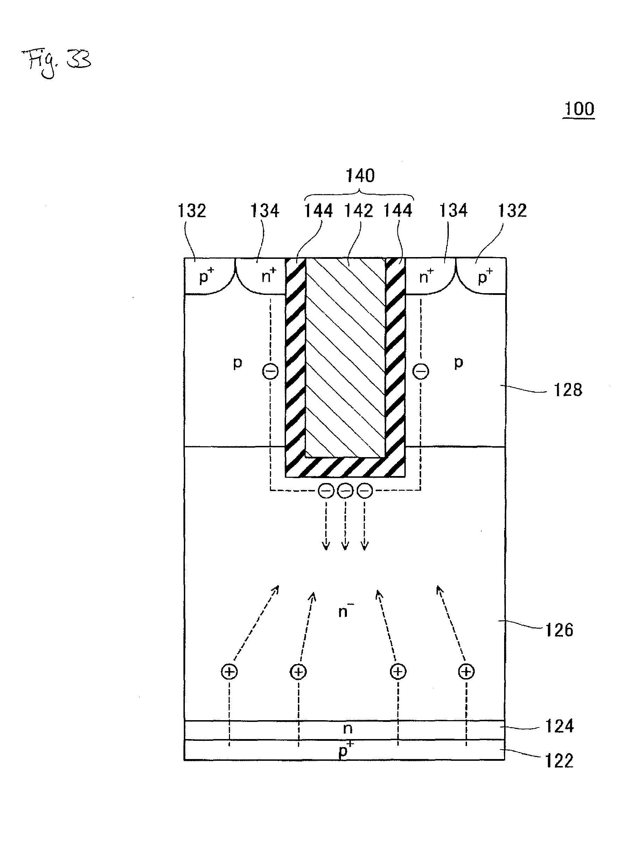

FIG.33 schematically shows a cross-sectional view of essential parts of an IGBT (Insulated Gate Bipolar Transistor) 100 with a trench gate 140. The IGBT 100 comprises a p⁺-type collector region 122, an n-type buffer region 124, an n⁻-type drift region 126, a p-type body region 128, a p⁺-type body contact region 132, an n⁺-type emitter region 134 and the trench gate 140. The trench gate 140 extends from the emitter region 134 toward the drift region 126, and penetrates the body region 128. The trench gate 140 includes a gate insulating layer 144 and a gate electrode 142 surrounded with the gate insulating layer 144.

As shown in FIG.33, when the IGBT 100 turns ON, electrons are provided from the emitter region 134. The electrons travel through the body region 128 along a surface of the trench gate 140, and are provided to the drift region 126. On the other hand, holes are provided from the collector region 122. The holes travel through the buffer region 122 and are provided to the drift region 126.

As shown in FIG.33, since the electrons provided from the emitter region 134 are attracted to a potential of the gate electrode 142, the electrons travel from side of the trench gate 140 to below thereof. On the other hand, since the holes provided from the collector region 122 are attracted to the electrons, the holes travel to below the trench gate 140. Therefore, the holes are concentrated below the trench gate 140. When the holes are concentrated below the trench gate 140, a gate capacity varies over time. For example, if the gate capacity varies over time when the IGBT 100 shifts from OFF state to ON state, a collector current and a voltage between the collector and emitter also vary over time, which gives rise to an occurrence of a surge voltage.

Japanese Patent Publication No. 2006-332591 and Japanese Patent Publication No. 2006-120951 each discloses a technique to form the gate insulating layer 144 of the trench gate 140 at the bottom to be thick. In this technique, numbers of the electrons traveling to below the trench gate 140 can decrease, so that numbers of the holes traveling to below the trench gate 140 can also decrease. As a result, the variation of the gate capacity over time can be repressed, and the occurrence of the surge voltage can be repressed.

### Disclosure of the Invention

### Problem to be Solved by the Invention

However, in a case that a gate potential applied to the gate electrode 142 is high, even if the gate insulating layer 144 is formed thick, the electrons are attracted to the potential of the gate electrode 142 and travel to below the trench gate 140, and the holes attracted to the electrons also travel to below thereof. The technique of forming thick gate insulating layer 144 does not provide a fundamental solution.

The purpose of the present invention is to provide a technique for physically repressing carriers to travel to below the trench gate.

### Means to Solve the Problem

The technique taught in this specification is **characterized in that** a projecting portion of an insulating material is disposed on a part of a surface of a trench gate. A part of the projecting portion projects within a drift region. Hence, since the part of the projecting portion projecting within the drift region is surrounded by the drift region, potential difference is not generated between one surface of the part of the projecting portion and another surface thereof that opposes the one surface. Therefore, an inversion layer is not formed at the surface of the part of the projecting portion. Due to this, the electrons provided from an emitter region can not travel beyond the projecting portion. As a result, the number of the electrons traveling to below the trench gate decreases, and the number of the holes traveling to below the trench gate by being attracted to the electrons also decreases.

That is, a semiconductor device taught in this specification comprises a surface semiconductor region of a first conductive type, a deep semiconductor region of the first conductive type, an intermediate semiconductor region of a second conductive type disposed between the surface semiconductor region and the deep semiconductor region, a trench gate, and a projecting portion of an insulating material being in contact with a surface of the trench gate. The trench gate extends in the intermediate semiconductor region from the surface semiconductor region toward the deep semiconductor region. The trench gate may penetrate the intermediate semiconductor region and irrupt into the deep semiconductor region, or alternately may not irrupt into the deep semiconductor region. In a case that the trench gate does not penetrate the intermediate semiconductor region, as described below, it is possible to flow carriers by using a second inversion layer at the projecting portion. The trench gate includes a gate insulating layer and a gate electrode surrounded with the gate insulating layer. At least a part of the projecting portion projects within the deep region.

In the above semiconductor device, the gate insulating layer of the trench gate may include a pair of side walls and a bottom wall. Each of the side walls is spreading from the surface semiconductor region toward the deep semiconductor region and opposes each other. The bottom wall is spreading from one of the side walls to another of the side walls. In this case, the projecting portion may be in contact with the bottom wall of the gate insulating layer or the side wall of the gate insulating layer.

When the projecting portion is in contact with the bottom wall of the gate insulating layer, it would be preferable that a plurality of projecting portions is in contact with the bottom wall of the gate insulating layer.
In the above semiconductor device, the intermediate semiconductor region can be formed by ion implantation technique. When the plurality of projecting portions is in contact with the bottom wall of the gate insulating layer, even if the intermediate semiconductor region diffuses to a deeper area than the depth of the trench gate, projecting portions can prevent the intermediate semiconductor region from diffusing to below the trench gate. Therefore, even if the intermediate semiconductor region diffuses to a deeper area than the depth of the trench gate, the deep semiconductor region can exist below the trench gate and between adjacent projecting portions. That is, the deep semiconductor region and the intermediate semiconductor region oppose each other with the projecting portion therebetween. In this case, when the semiconductor device is in an ON state, potential difference is generated between the deep semiconductor region and the intermediate semiconductor region so that the second inversion layer is formed at the part of the surface of the projecting portion where the intermediate semiconductor region is in contact. Therefore, the carriers provided from the surface semiconductor region can travel to the deep semiconductor region by passing through the second inversion layer. In the conventional trench gate, when the intermediate semiconductor region diffuses deeper than the depth of the trench gate, it had become impossible to shift between the ON state and an OFF state. However, in the above semiconductor device, when the plurality of projecting portions is disposed on the bottom wall of the gate insulating layer, even if the intermediate semiconductor region diffuses to the area deeper than the depth of the trench gate, there is no trouble with shifting between the ON state and the OFF state. The semiconductor device with the above configuration is characterized in its easy manufacture. Further, as described above, since the part of the projecting portion exists within the deep semiconductor region, the second inversion layer is not formed at the part of the projecting portion. Therefore, the carriers do not travel beyond the projecting portion and reach to below the trench gate. That is, the projecting portion with the above configuration has an effect of easy manufacture of the semiconductor device, in addition to an effect of physically repressing the carriers from traveling to below the trench gate.

When the plurality of projecting portions is in contact with the bottom wall of the gate insulating layer, it would be preferable that the above semiconductor device further comprises a bottom wall semiconductor region of the second conductive type disposed between adjacent projecting portions. Further, it would be preferable that the bottom wall semiconductor region is electrically floating.
When the electrically floating bottom wall semiconductor region is formed below the trench gate, it is possible to reduce a gate capacity and to realize high speed switching.

The technique taught in this specification can also provide a method of manufacturing a trench gate. The method of manufacturing the trench gate taught in this specification comprises a first step of forming a first trench with a first depth in a part of a surface of a semiconductor substrate within a trench gate forming region by dry etching. Further, the method of manufacturing the trench gate comprises a second step of forming a second trench with a second depth in a remaining portion of the surface of the semiconductor substrate within the trench gate forming region by dry etching. The first depth is deeper than the second depth. The first step may be carried out before the second step, or alternately, the second step may be carried out before the first step.
In the above manufacturing method, the first trench can be formed deeper than the second trench. Hence, the first trench projecting from the second trench can become a projecting trench projecting from a bottom surface of the trench gate. When at least a part of the projecting trench is located within the deep semiconductor region, both of side surfaces that oppose each other of the part of the projecting trench can be in contact with the deep semiconductor region. Therefore, since potential difference is not generated between the one surface of the part of the projecting trench and another surface thereof, an inversion layer is not formed on the surface of the part of the projecting trench. That is, in the above manufacturing method, the trench gate realizing the technique taught in this specification can be manufactured.
Further, the location at which the first trench is formed may be at least in a part of the trench gate forming region. For example, when the first trench is formed in a center of the trench gate forming region, the projecting trench projecting from the center of the bottom surface of the trench gate is formed. It would be preferable that the first trench is formed at least in a part of an area along a peripheral of the trench gate forming region. It would be more preferable that the first trench is formed along the entire peripheral of the trench gate forming region.

The techniqe taught in this specification can also provide other manufactuirng method of the trench gate. The manufacturing method of the trench gate taught in this specification comprises a first step of forming a plurality of trenches in a part of a surface of a semiconductor substrate within a trench gate forming region by dry etching. Further, the manufacturing method of the trench gate comprises a second step of providing an etchant into the plurality of trenches and forming a projecting trench projecting downwardly from a bottom surface of the trench by wet etching. A side surface of the trench formed by the first step has a first plane direction, and a side surface of the projecting trench formed by the second step has a second plane direction. The first plane direction and the second plane direction are non-parallel. Also, in the second step, a wall between trenches may be removed by the wet etching, or alternately, may not be removed as needed. For example, a step of oxidizing the wall between trenches may be added, and the trench gate may thereby be separated into a plurality of rooms.
In the aforesaid manufacturing method, the projecting trench projecting downwardly from the bottom surface of each of the trenches can be formed by forming the trench gate with a combination of dry etching and wet etching. In the above manufacturing method, since the plurality of trenches forms a single trench gate, a plurality of projecting trenches may be formed on the bottom surface of the trench gate. When at least a part of these projecting trenches is located within the deep semiconductor region, both of the side surfaces that oppose each other of the part of the projecting trench can be in contact with the deep semiconductor region. Therefore, since potential difference is not generated between the one surface of the part of the projecting trench and another surface thereof, an inversion layer is not formed on the surface of the part of the projecting trench. That is, in the above manufacturing method, the trench gate realizing the technique taught in this specification can be manufactured.
Further, when the semiconductor substrate is a silicon substrate, it would be preferable that the first plane direction is (100) and the second plane direction is (111). In this case, HBr gas can be used for the dry etching and KOH solution can be used for the wet etching.

The techniqe taught in this specification can also provde other manufactuirng method of the trench gate. The manufacturing method of trench gate taught in this specification comprises a first step of forming a trench in a surface of a semiconductor substrate within a trench gate forming region by dry etching. Further, the manufacturing method of the trench gate comprises a second step of deepening the trench by dry etching under a condition that a volatile compound, produced during the dry etching, in which the semiconductor substrate and an etching gas are combined, deposits on a bottom surface of the trench.
In the above manufacturing method, the trench is formed by performing dry etching for at least two times. The dry etching at the second step is carried out under the condition that the volatile compound in which the semiconductor substrate and the etching gas are combined deposits on the bottom surface of the trench. In general, when the volatile compound deposits on the bottom surface of the trench, much of the volatile compound deposits at a center of the bottom surface of the trench. Hence, if the dry etching is continued under the aforesaid condition, the etching at the peripheral side on the bottom surface progresses faster than the etching at the center on the bottom surface. As a result, a projecting trench can be formed at the peripheral side on the bottom surface of the trench. When at least a part of the projecting trench is located within the deep semiconductor region, both of the side surfaces that oppose each other of the part of the projecting trench can be in contact with the deep semiconductor region. Therefore, since potential difference is not generated between the one surface of the part of the projecting trench and another surface thereof, an inversion layer is not formed on the surface of the part of the projecting trench. That is, in the above manufacturing method, the trench gate realizing the technique taught in this specification can be manufactured.

The techniqe taught in this specification can also provde other manufactuirng method of the trench gate. The manufacturing method of the trench gate taught in this specification comprises a first step of forming a mask on a part of a surface of a semiconductor substrate within a trench gate forming region, and a second step of forming a trench at the surface of the semiconductor substrate within the trench gate forming region by dry etching. In the second step, the dry etching is continued even after the mask on the surface of the trench gate forming region has disappeared.
The second step of the above manufacturing method can be separated into two phases. In a first phase, the surface of the trench forming region that is not covered with the mask is etched. In the first phase, although an etching rate is low, the mask formed on the surface of the trench gate forming region is also gradually etched, which eventually disappears. At the time when the mask disappears, the etching at the part where the mask had not been covering has progressed, and an initial trench has thereby been formed. That is, in the first phase, a difference in a degree of progress of etching is caused at the trench gate forming region by forming the mask at the part of the surface of the trench forming region. Next, in a second phase, the trench at the trench forming region is further deepened by continuing dry etching even after the mask has disappeared. Due to the difference of the degree of progress of etching, the projecting trench has thereby been formed on the bottom surface of the trench when the second phase is finished. When at least a part of the projecting trench is located within the deep semiconductor region, both of the side surfaces that oppose each other of the part of the projecting trench can be in contact with the deep semiconductor region. Therefore, since potential difference is not generated between the one surface of the part of the projecting trench and another surface thereof, an inversion layer is not formed on the surface of the part of the projecting trench. That is, in the above manufacturing method, the trench gate realizing the technique taught in this specification can be manufactured.
Further, in the first step, it would be preferable that a plurality of masks is dispersed on the surface in the trench gate forming region. The trench with a wide width can be formed by arranging the plurality of masks in a dispersed pattern.

### Effects of the Invention

The projecting portion taught in this specification can physically prevent a first type of carriers provided from the surface semiconductor region from traveling to below the trench gate. Therefore, it can prevent a second type of carriers that are attracted to the first type of carriers from concentrating below the trench gate. As a result, it can repress the variation of the gate capacity over time caused by the concentration of carriers, and provide a semiconductor device that can withstand a high voltage.

### Brief Description of the Drawings

FIG. 1 shows a schematic cross sectional view of an essential part of the IGBT 10 (the cross sectional view corresponding to I-I line in the FIG.4).
FIG. 2 shows a schematic cross sectional view of an essential part of the IGBT 10 (the cross sectional view corresponding to II-II line in the FIG.4).
FIG. 3 shows a schematic cross sectional view of an essential part of the IGBT 10 (the cross sectional view corresponding to III-III line in the FIG.4).
FIG. 4 shows a schematic top view of the essential parts of the IGBT 10.
FIG. 5 shows a schematic cross sectional view of an essential part of a modified embodiment of the IGBT 10.
FIG. 6 shows a schematic cross sectional view of an essential part of a modified embodiment of the IGBT 10.
FIG. 7 shows a schematic cross sectional view of an essential part of a modified embodiment of the IGBT 10.
FIG. 8 shows a schematic cross sectional view of an essential part of a modified embodiment of the IGBT 10.
FIG. 9 shows a schematic cross sectional view of an essential part of a modified embodiment of the IGBT 10.
FIG. 10 shows a schematic cross sectional view of an essential part of a modified embodiment of the IGBT 11.
FIG. 11 shows a schematic cross sectional view of an essential part of a modified embodiment of the IGBT 12.
FIG. 12 shows a schematic cross sectional view of an essential part of a modified embodiment of the IGBT 13.
FIG. 13 shows a schematic cross sectional view of an essential part of a modified embodiment of the IGBT 14.
FIG. 14 shows a step of a first manufacturing method of the trench gate (1).
FIG. 15 shows a step of the first manufacturing method of the trench gate (2).
FIG. 16 shows a step of the first manufacturing method of the trench gate (3).
FIG. 17 shows a step of the first manufacturing method of the trench gate (4).
FIG. 18 shows a step of the first manufacturing method of the trench gate (5).
FIG. 19 shows a step of the first manufacturing method of the trench gate (6).
FIG. 20 shows a step of a second manufacturing method of the trench gate (1).
FIG. 21 shows a step of the second manufacturing method of the trench gate (2).
FIG. 22 shows a step of the second manufacturing method of the trench gate (3).
FIG. 23 shows a step of a third manufacturing method of the trench gate (1).
FIG. 24 shows a step of the third manufacturing method of the trench gate (2).
FIG. 25 shows a step of the third manufacturing method of the trench gate (3).
FIG. 26 shows a step of the third manufacturing method of the trench gate (4).
FIG. 27 shows a step of a forth manufacturing method of the trench gate (1).
FIG. 28 shows a step of the forth manufacturing method of the trench gate (2).
FIG. 29 shows a step of the forth manufacturing method of the trench gate (3).
FIG. 30 shows a step of a modified embodiment of the forth manufacturing method of the trench gate (1).
FIG. 31 shows a step of the modified embodiment of the forth manufacturing method of the trench gate (2).
FIG. 32 shows a step of the modified embodiment of the forth manufacturing method of the trench gate (3).
FIG. 33 shows a schematic cross sectional view of an essential part of a conventional IGBT 100.

### Preferred Features for Realizing the Invention

Several features taught in this specification will be listed.
(First feature) A semiconductor device comprises a trench gate and a projecting portion being in contact with the trench gate. The projecting portion includes a surface whose potential is not varied based on the gate potential.
(Second feature) A semiconductor device comprises a trench gate and a projecting portion being in contact with the trench gate. Thickness of the projecting portion in a projecting direction from the gate insulating layer is thicker than thickness of the gate insulating layer.
(Third feature) A semiconductor device comprises a trench gate and a projecting portion being in contact with the trench gate. The projecting portion includes a first surface and a second surface opposing the first surface. The first surface and the second surface oppose each other along a line between the emitter region and below the trench gate.
(Forth feature) A semiconductor device comprises a trench gate and a projecting portion being in contact with the trench gate. The projecting portion is disposed at a peripheral portion of a bottom surface of a gate insulating layer.

### Embodiments

Embodiments will be described below with reference to the figures. Note that common configurations among the figures are given the same reference numbers, and explanations thereof are omitted accordingly. Further, although a non-punch through type IGBT will be described in the embodiments below, the technique taught in the present specification may also be applied to a punch through type IGBT. Also, in IGBTs described in the embodiments below, silicon is used for the semiconductor material. However, the technique taught in the present specification may also be applied to IGBTs made from semiconductor material other than silicon. For example, the technique taught in the present specification may also be applied to IGBTs made from compound semiconductors such as gallium nitride, silicon carbide, and gallium arsenide.

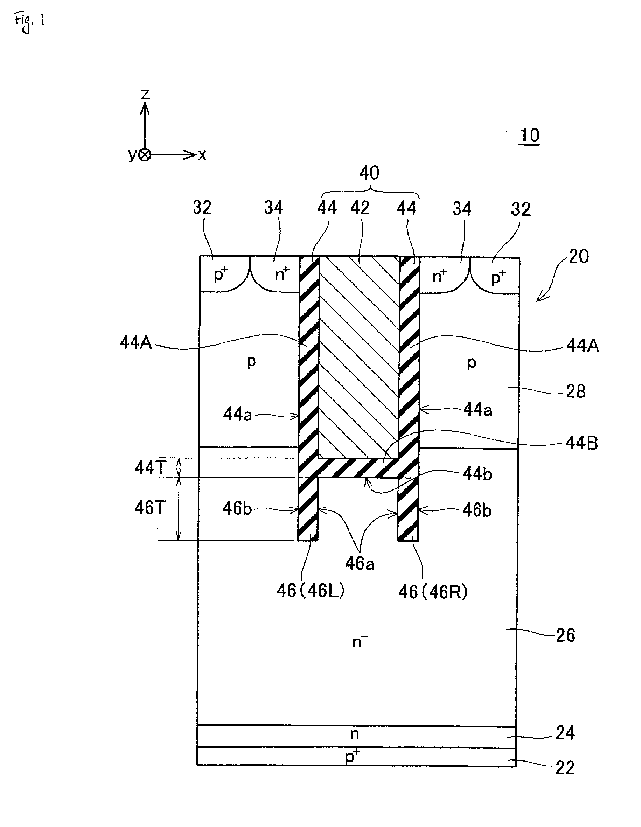

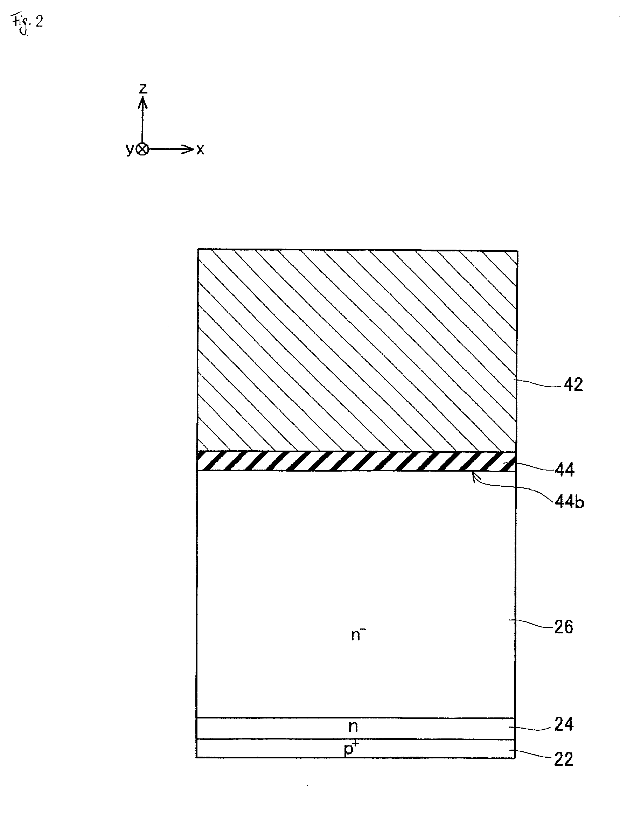

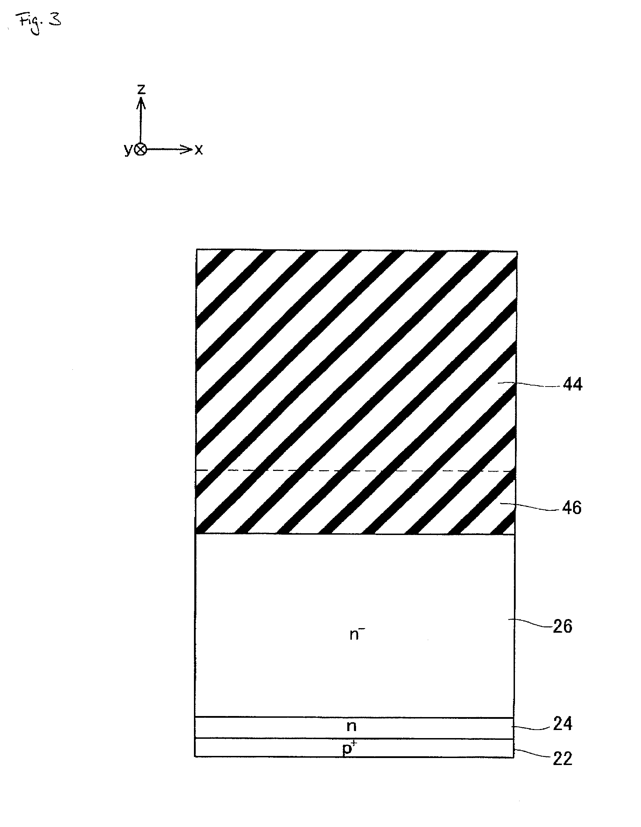

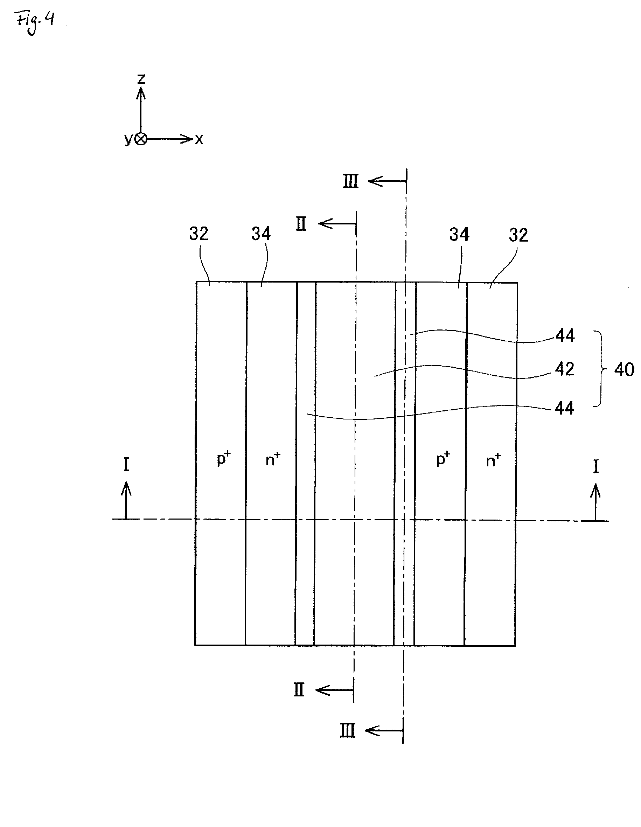

FIGS.1-3 schematically show cross-sectional views of essential parts of an IGBT 10, and FIG.4 shows a top view of the essential parts of the IGBT 10. FIG.1 is the cross-sectional view corresponding to the I-I line in the FIG.4, FIG.2 is the cross-sectional view corresponding to the II-II line in the FIG.4, and FIG.3 is the cross-sectional view corresponding to the III-III line in the FIG.4. Note that FIGS. 1-4 show a basic structure of IGBT 10. Therefore, in fact, one semiconductor device is configured with the basic structures being repeatedly provided.

As shown in FIG.1, the IGBT 10 is formed with a semiconductor substrate 20 of monocrystalline silicon. The IGBT 10 comprises a p⁺-type collector region 22, an n-type buffer region 24 disposed on the collector region 22, an n⁻-type drift region 26 (one example of a deep semiconductor region) disposed on the buffer region 24, a p-type body region 28 (one example of an intermediate semiconductor region) disposed on the drift region 26. The collector region 22 is electrically connected to an undepicted collector electrode. The collector region 22 and the buffer region 24 are formed in a bottom surface portion of the semiconductor substrate 20 by ion implantation technique. The body region 28 is also formed in an upper surface portion of the semiconductor substrate 20 by ion implantation technique. The n-type drift region 26 and the n-type buffer region 24 separate the p-type body region 28 and the p-type collector region 22.

The IGBT 10 further comprises p⁺-type body contact regions 32 and n⁺-type emitter regions 34 (one example of a surface semiconductor region) selectively disposed on the body region 28 in a distributed alignment. The emitter regions 34 are in contact with the side surface of a trench gate 40. The emitter regions 34 and the drift region 26 are separated by the body region 28. The body contact regions 32 and the emitter regions 34 are electrically connected to an undepicted emitter electrode. The body contact regions 32 and the emitter regions 34 are formed in the upper surface portion of the semiconductor substrate 20 by ion implantation technique.

The IGBT 10 further comprises the trench gate 40. The trench gate 40 extends along a vertical direction (z axis direction) in the body region 28 from the emitter region 34 toward the drift region 26. The trench gate 40 penetrates the body region 28, one end of the trench gate 40 is in contact with the emitter region 34, and another end of the trench gate 40 intrudes into the drift region 26. The trench gate 40 comprises a gate insulating layer 44 and a gate electrode 42 surrounded with the gate insulating layer 44. The gate insulating layer 44 is made from oxide silicon, and the gate electrode 42 is made from polysilicon having a high concentration of impurities.

As shown in FIG.1, the gate insulating layer 44 comprises a pair of side walls 44A and a bottom wall 44B. The pair of side walls 44A spreads along the vertical direction (z axis direction) from the emitter region 34 toward the drift region 26, and opposes each other in a lateral direction (x axis direction). The bottom wall 44B spreads along the lateral direction (x axis direction) from the one of side wall 44A to another one of side wall 44A. A side surface 44a of the side wall 44A is in contact with the emitter region 34, the body region 28 and the drift region 26. A bottom surface 44b of the bottom wall 44B is in contact with the drift region 26. As shown in FIG.4, in a plane view, the trench gate 40 extends along the y axis direction.

As shown in FIG.1, the IGBT 10 further comprises two projecting portions 46 that downwardly project from the bottom wall 44B of the trench gate 40 within the drift region 26. A right side projecting portion 46R is disposed to be in contact with a right side circumferential edge of the bottom wall 44B of the gate insulating layer 44. A left side projecting portion 46L is disposed to be in contact with a left side circumferential edge of the bottom wall 44B of the gate insulating layer 44. As shown in the FIG.3, the projecting portions 46 spread along a longitudinal direction (y-axis direction) of the trench gate 40 and are in contact with the bottom wall 44B of the gate insulating layer 44 in the longitudinal direction (y-axis direction). The projecting portions 46 are made from oxide silicon.

As shown in the FIG.1, the projecting portions 46 each comprise a first surface 46a and a second surface 46b opposing the first surface 46a. The first surface 46a and the second surface 46b both are located in a line between the emitter region 34 and below the trench gate 40, and oppose each other along the line. Further, first surface 46a and the second surface 46b both are in contact with the drift region 26. The first surface 46a is not parallel to the bottom surface 44b of the gate insulating layer 44, and is discontinuously in contact with the bottom surface 44b of the gate insulating layer 44. The second surface 46b is parallel to the side surface 44a of the gate insulating layer 44, and is continuously in contact with the side surface 44a of the gate insulating layer 44. Thickness 46T of the projecting portion 46 in a direction (z axis direction) that the projecting portion 46 projects from the bottom wall 44B of the gate insulating layer 44 is thicker than thickness 44T of the bottom wall 44B of the gate insulating layer 44.

Next, the characteristic of the IGBT 10 will be described. The IGTB 10 is characterized in comprising the projecting portion 46. Further, both of the first surface 46a and the second surface 46b of the projecting portion 46 are characterized in being in contact with the drift region 26. Since both of the first surface 46a and the second surface 46b are in contact with the drift region 26, potential difference is not generated between the first surface 46a and the second surface 46b. Hence, an inversion layer is not formed at the first surface 46a and the second surface 46b of the projecting portion 46. Therefore, the electrons provided from the emitter region 34 cannot travel beyond the projecting portion 46 and thus cannot reach below the trench gate 40. As a result, number of the electrons traveling to below the trench gate 40 decreases, and number of the holes traveling to below the trench gate 40 due to being attracted to the electrons also decreases.

As mentioned in the above section of the Problem to be Solved, if the holes are concentrated below the trench gate 40, the gate capacity varies over time and it becomes a trigger to an occurrence of a surge voltage. In the IGBT 10, the electrons are physically repressed from travelling to below the trench gate 40 by disposing the projecting portion 46. As a result, the gate capacity is repressed from varying over time, and the IGBT 10 with high withstand voltage is realized.

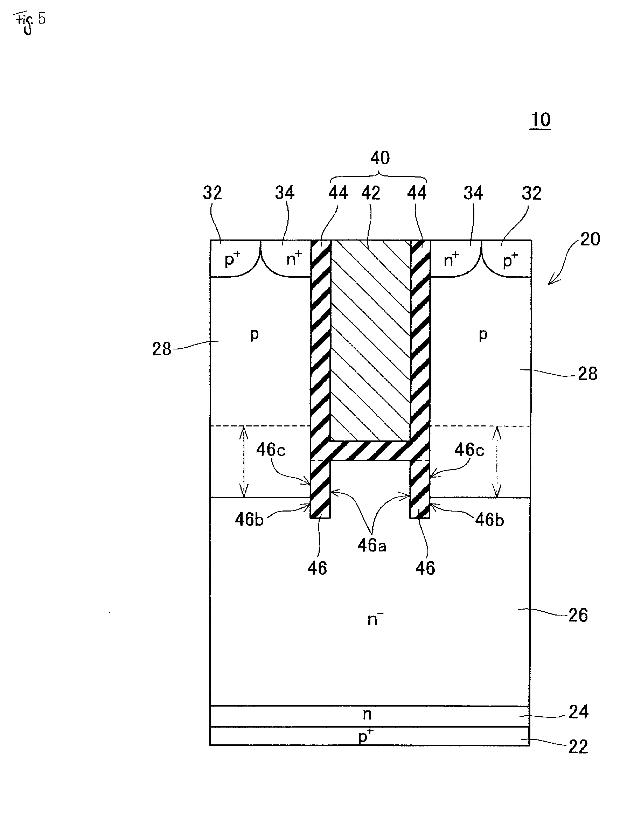

Further, the IGBT 10 has following characteristics. As mentioned above, the body region 28 of the IGBT 10 is formed by the ion implantation technique. As shown in FIG.5, when the body region 28 is thermally diffused, the body region 28 may diffuse to a deeper area than the depth of the trench gate 40. In this case, as shown in FIG.5, projecting portions 46 can prevent the body region 28 from diffusing to below the trench gate 40. Therefore, even if the body region 28 diffuses to the deeper area than the depth of the trench gate 40, the drift region 26 can exist below the trench gate 40 and between the adjacent projecting portions 46. Therefore, even if the body region 28 diffuses to the deeper area than the depth of the trench gate 40, the body region 28 and the drift region 26 oppose each other with the projecting portion 46 therebetween. In this case, when the IGBT 10 is in the ON state, potential difference is generated between the drift region 26 and the body region 28, so that a second inversion layer is formed at a part 46c of the second surface 46b of the projecting portion 46. Hence, the electrons provided from the emitter region 34 can travel through the second inversion layer and can reach the drift region 26. Therefore, in the IGBT 10, when the body region 28 is formed by the ion implantation technique, even if the body region 28 diffuses to the deeper area than the depth of the trench gate 40, there is no problem to shift between the ON state and the OFF state. It can be evaluated that the IGBT 10 has a configuration that can mitigate manufacturing tolerances of the ion implantation technique.
As mentioned above, a portion of the projecting portion 46 exists within the drift region 26, so the second inversion layer is not formed at the aforesaid portion. Therefore, the electrons do not travel beyond the projecting portion 46 and thus do not reach below the trench gate 40. That is, the projecting portion 46 of the IGBT 10 has an effect of easy manufacture of the IGBT 10, in addition to an effect of physically repressing the electrons from traveling to below the trench gate 40.

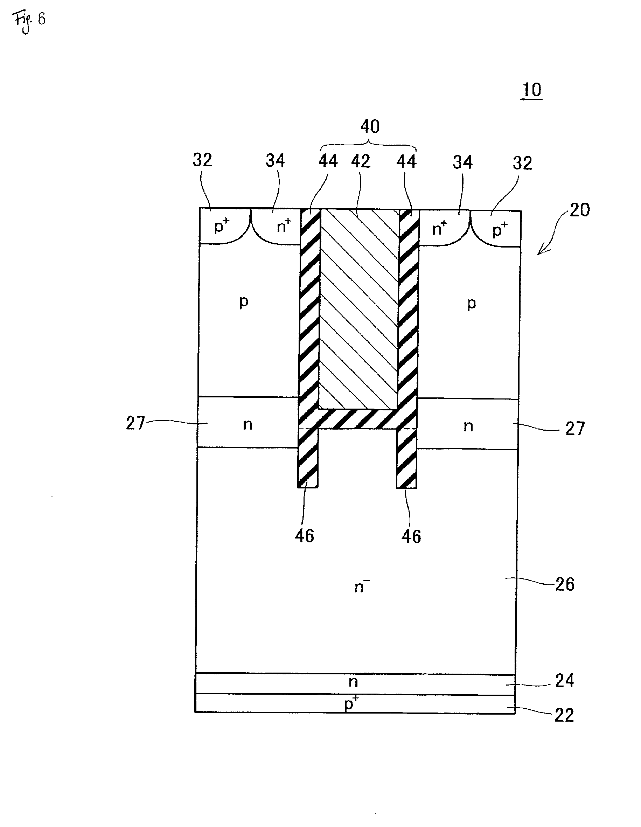

Several modified embodiments of the IGBT 10 will be described below.
The IGBT 10 of a modified embodiment depicted in FIG.6 is characterized in disposing an n-type hole accumulating layer 27 between the drift region 26 and the body region 28. The hole accumulating layer 27 forms energy barrier against the holes, and prevents the holes from traveling from the drift region 26 to the body region 28. As a result, concentration of the holes in the drift region 26 can be made high. Therefore, a resistance value of the drift region 26 can be lowered, and thus the on-voltage can be made low.

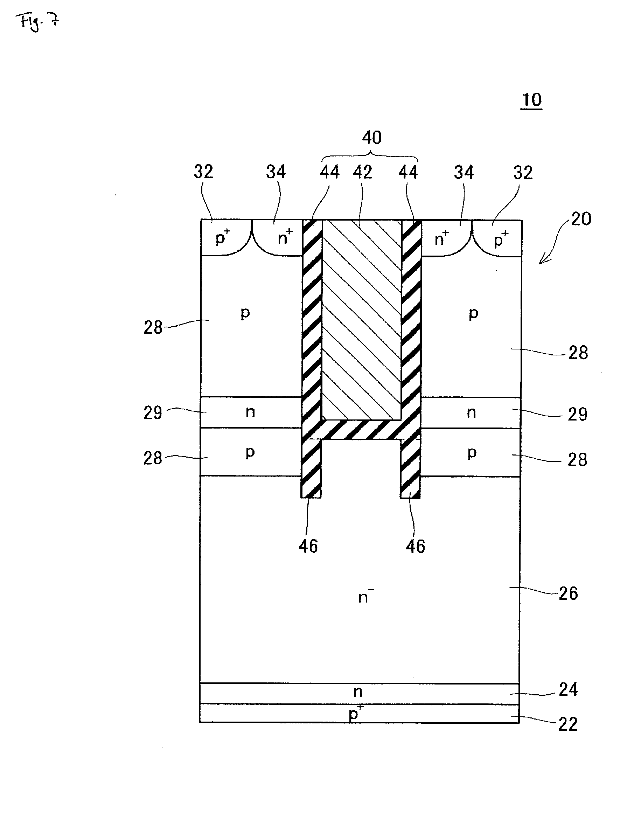

The IGBT 10 of a modified embodiment depicted in FIG.7 is characterized in disposing an n-type hole accumulating layer 29 in the body region 29. The hole accumulating layer 29 forms energy barrier against the holes, and can cause concentration of the holes in the body region 28 to be high. Therefore, a resistance value of the body region 28 can be lowered, and the on-voltage can be made low.

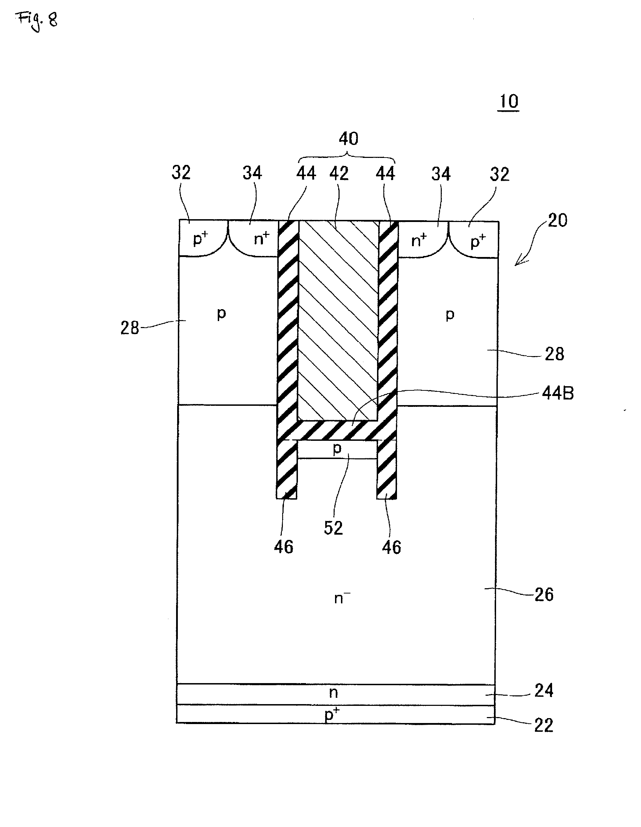

The IGBT 10 of a modified embodiment depicted in FIG.8 is characterized in disposing a p-type floating semiconductor region (one of example of a bottom wall semiconductor region) 52 between adjacent projecting portions 46. The floating semiconductor region 52 is in contact with the bottom wall 44B of the gate insulating layer 44. The floating semiconductor region 52 is electrically insulated from the body region 28, and the potential of the floating semiconductor region 52 varies based on the potential of the drift region 26. When the floating semiconductor region 52 is disposed below the trench gate 40, a gate capacity can be lowered, and a switching seed can be made high.
Note that an i-type floating semiconductor region may be formed instead of the p-type floating semiconductor region 52.

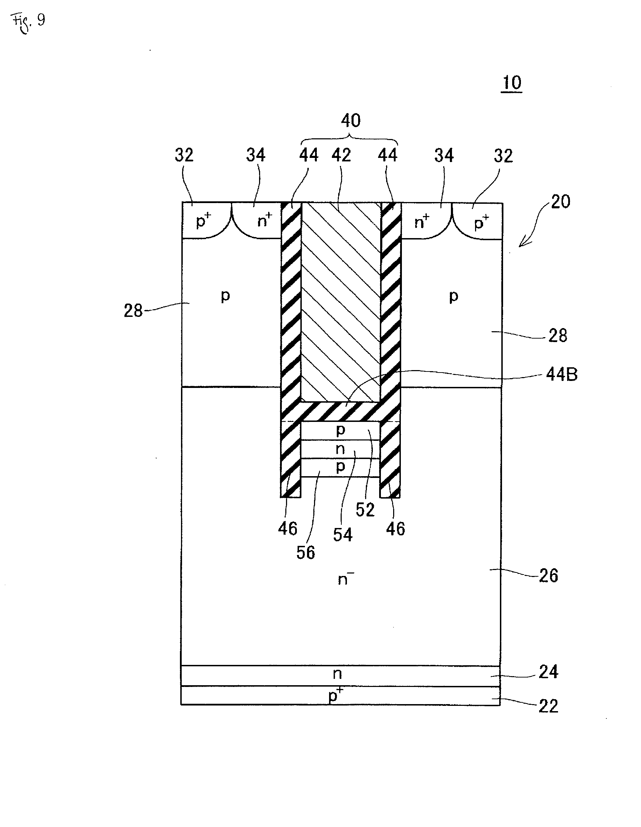

The IGBT 10 of a modified embodiment depicted in FIG.9 is characterized in disposing a stacked layer of the p-type floating semiconductor region 52, an n-type floating semiconductor region 54 and a p-type floating semiconductor region 56 between adjacent projecting portions 46. The function and effect thereof is the same as the embodiment depicted in FIG.8; the gate capacity can be lowered, and the switching seed can be made high.

Several modified embodiments with different configurations of the projecting portions will be described below.

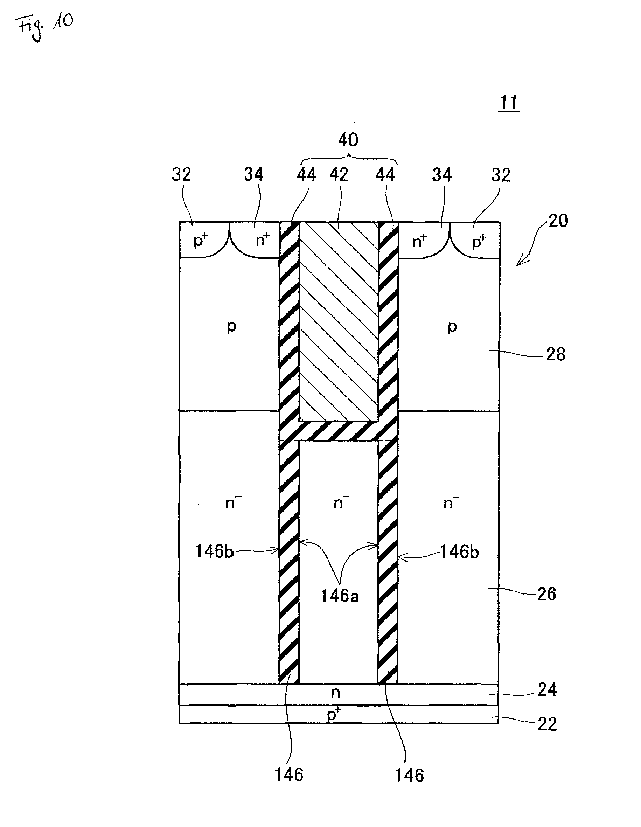

FIG.10 schematically shows a cross-sectional view of an essential part of an IGBT 11. The IGBT 11 is **characterized in that** a projecting portion 146 penetrates the drift region 26 and reaches the buffer region 24. In the IGBT 11, the electrons provided from the emitter region 34 are completely prevented from traveling to below the trench gate 40. Therefore, the phenomenon in which the holes provided from the collector region 22 concentrate below the trench gate 40 is drastically repressed.
Further, in the IGBT 11, it would be preferable that the collector region 22 is not formed between adjacent projecting portions 146 in plan view. In this case, no holes are provided to the drift region 26 between the adjacent projecting portions 146, thus the phenomenon in which the holes concentrate below the trench gate 40 is further repressed.

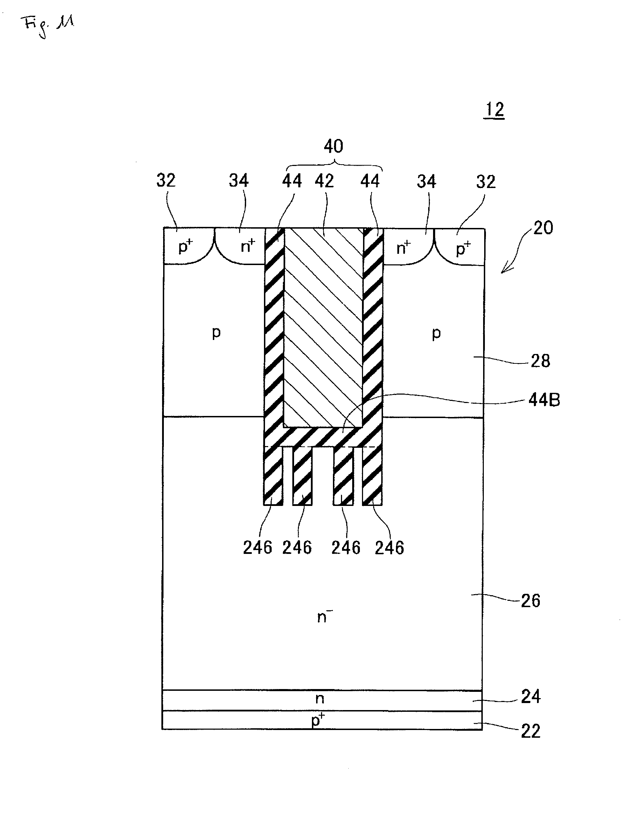

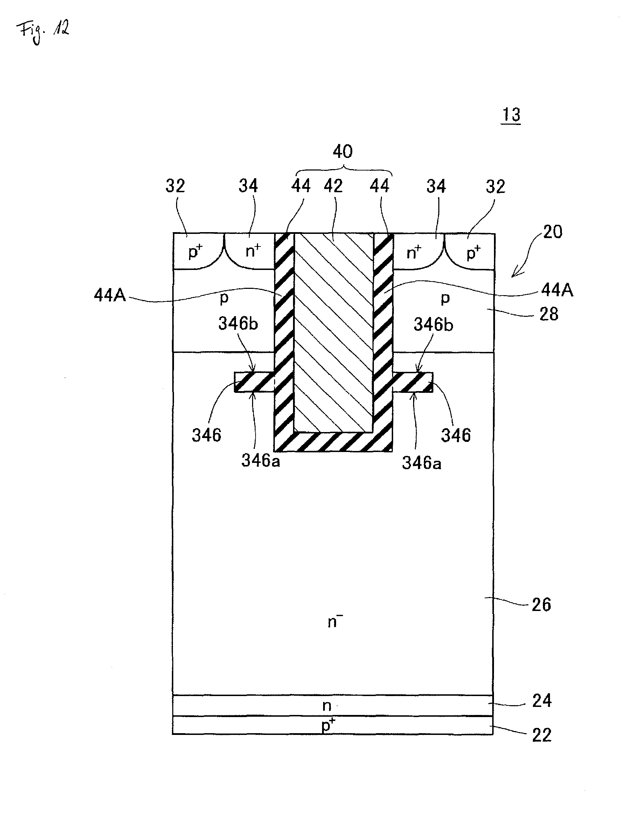

FIG.11 schematically shows a cross-sectional view of an essential part of an IGBT 12. The IGBT 12 is **characterized in that** four projecting portions 246 are disposed to be in contact with the bottom wall 44B of the gate insulating layer 44. As shown in the FIG.12, number of projecting portions 246 disposed on the bottom surface of the trench gate 40 is not specifically restricted. Note that this configuration can be formed by a second manufacturing method described below.

FIG.12 schematically shows a cross-sectional view of an essential part of an IGBT 13. The IGBT 13 is **characterized in that** two projecting portions 346 are disposed to be in contact with the side wall 44A of the gate insulating layer 44. In this embodiment, both of a first surface 346a and a second surface 346b of the projecting portion 346 are disposed in a line between the emitter region 34 and below of the trench gate 40. Further, both of the first surface 346a and the second surface 346b of the projecting portion 346 are in contact with the drift region 26. Therefore, the electrons provided from the emitter region are physically prevented from traveling beyond the projecting portion 346 and reaching to below the trench gate 40.

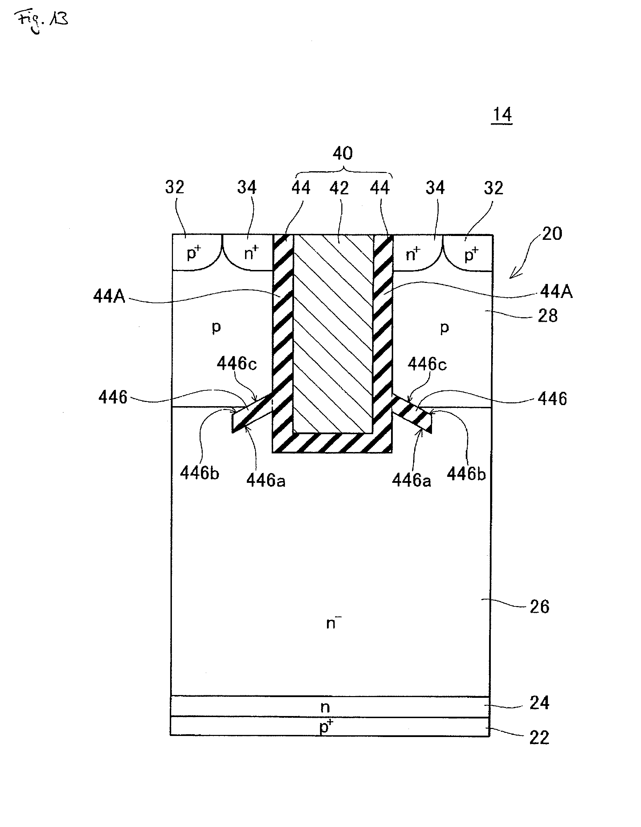

FIG.13 schematically shows a cross-sectional view of an essential part of an IGBT 14. The IGBT 14 is **characterized in that** one end of a projecting portion 446 is in contact with the side wall 44A of the gate insulating layer 44 located in the body region 28. Further, the projecting portion 446 is **characterized in that** another end intrudes into the drift region 26. In this embodiment, both of the first surface 446a and the second surface 446b of the projecting portion 446 are disposed in the line between the emitter region 34 and below the trench gate 40. Further, parts of the first surface 446a and the second surface 446b are in contact with the drift region 26. Therefore, the electrons provided from the emitter region 34 are physically prevented from traveling beyond the projecting portion 446 and reaching to below the trench gate 40.
Further, a part 446c of the second surface 446b of the projecting portion 446 opposes the drift region 26. Hence, when the IGBT 124 is in the ON state, potential difference between the drift region 26 and the body region 28 occurs so that the second inversion layer is generated at the part 446c of the second surface 446b of the projecting portion 446. Therefore, the electrons provided from the emitter region 34 can travel through the second inversion layer and can reach the drift region 26.

Several methods for manufacturing the trench gates for the above IGBTs will be described below. The manufacturing methods described below will explain only some steps that are favorably used for manufacturing the new trench gates which are disclosed in this specification for the first time. The conventionally known techniques can be used for other steps that are needed to manufacture the IGBT.

### (The first manufacturing method of the trench gate)

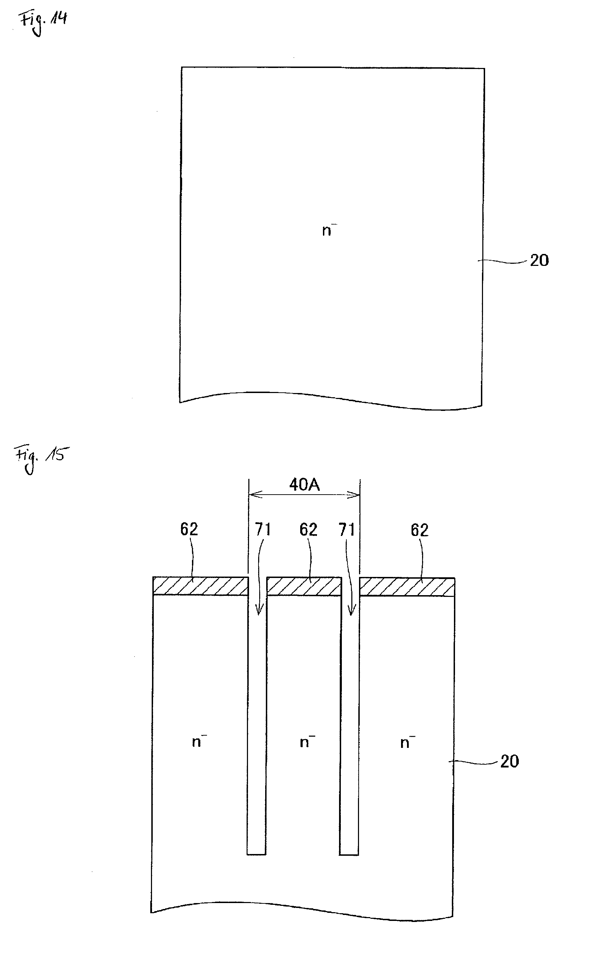

The first manufacturing method of the above trench gate 40 will be described with reference to FIGS.14-18 below.
First, as shown in FIG.14, the n⁻-type semiconductor substrate 20 is prepared.

Next, as shown in FIG.15, a mask 62 is patterned on the surface of the semiconductor substrate 20. The CVD oxide layer is used for the material of the mask 62. The openings of the mask 62 are formed at least in a part of an area that is along the edge of the trench forming region 40A of the semiconductor substrate 20. More preferably, the openings of the mask 62 are formed around the edge of the trench forming region 40A of the semiconductor substrate 20. Next, the surface of the semiconductor substrate 20 which is exposed from the openings of the mask 62 is etched to form a first trench 71 extending in the semiconductor substrate 20 by dry etching technique. In the dry etching, HBr gas is used as the etching gas. After forming the first trench 71, the mask 62 is removed.

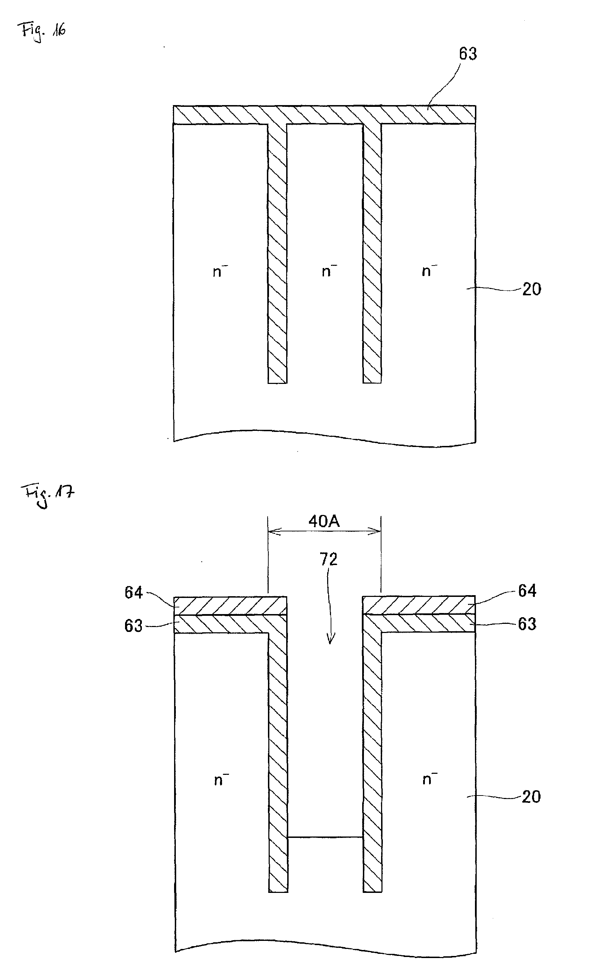

Next, as shown in FIG.16, the first trench 71 is filled with a thermally oxidized film 63 by thermal oxidation technique.

Next, as shown in FIG.17, a mask 64 is patterned on the surface of the thermally oxidized film 63. The opening of the mask 64 is formed at an area that corresponds to the area that the first trench 71 is not formed in the trench forming region 40A. Next, the thermally oxidized film 63 which is exposed from the opening of the mask 64 and the semiconductor substrate 20 under the thermally oxidized film 63 are etched to form a second trench 72 by dry etching technique. In this dry etching, CF₄ and HBr are used as the etching gas. The depth of the second trench 72 is shallower than the depth of the first trench 71.

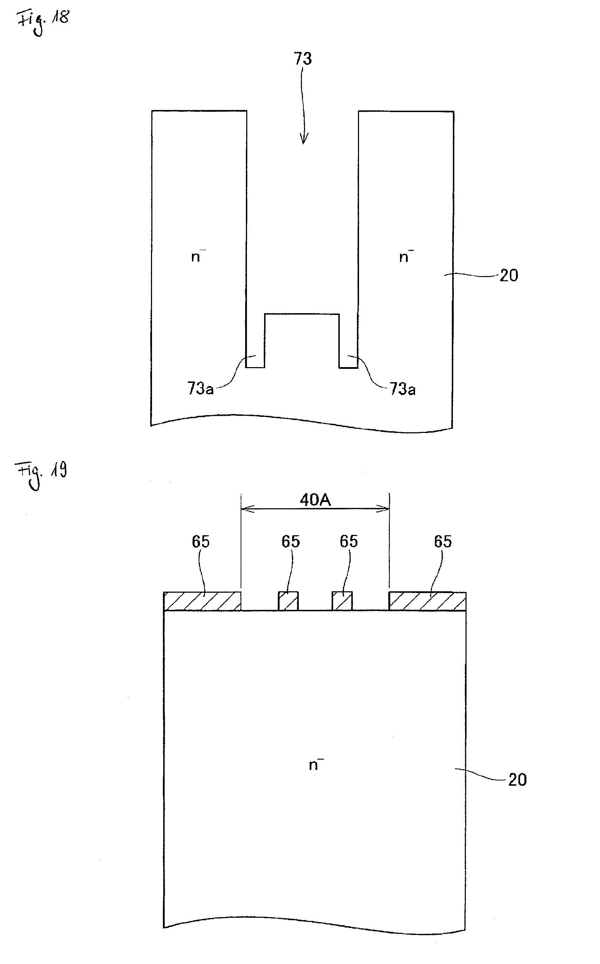

Next, after removing the thermally oxidized film 63 and the mask 64, a trench 73 depicted in FIG.18 is formed. In the above manufacturing method, the first trench 71 is formed to be deeper than the second trench 72. Therefore, the first trench 71 projecting from the second trench 72 becomes a projecting trench 73a that projects from the edge of the bottom surface of the trench 73. After this, a thermally oxidized film is filled in the projecting trench 73a by the thermal oxidation technique, and thereby the projecting portion described in this specification is formed. Further, the gate insulating layer and the gate electrode can be formed to complete the trench gate by the conventionally known thermal oxidation technique and CVD (Chemical Vapor Deposition) technique.

### (The second manufacturing method of the trench gate)

The second manufacturing method of the trench gate 40 will be described with reference to FIGS. 19-22 below.
First, as shown in FIG.19, a mask 65 is patterned on the surface of the semiconductor substrate 20. The CVD oxide layer is used for the material of the mask 65. A plurality of the openings of the mask 65 is formed in the trench forming region 40A of the semiconductor substrate 20.

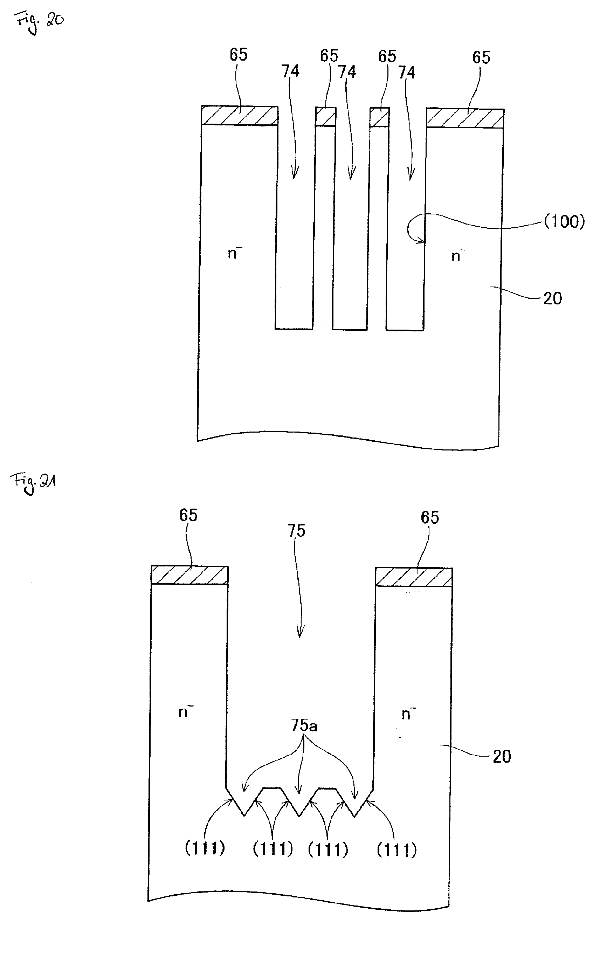

Next, as shown in FIG.20, the surface of the semiconductor substrate 20 which is exposed from the openings of the mask 65 is etched to form a plurality of trenches 74 extending in the semiconductor substrate 20 by dry etching technique. In this dry etching, HBr gas is used as the etching gas. Therefore, the side surface of the plurality of trenches 74 is [100] phase.

Next, as shown in FIG.21, etchant is provided into the plurality of trenches 74, and a projecting trench 75a projecting downwardly from the bottom surface of the trench 74 is formed. KOH solution is used as the etchant. Therefore, the side surface of the projecting trench 75a is [111] phase. In this wet etching, the walls between the trenches 74 are also removed, and one single trench 75 is formed.

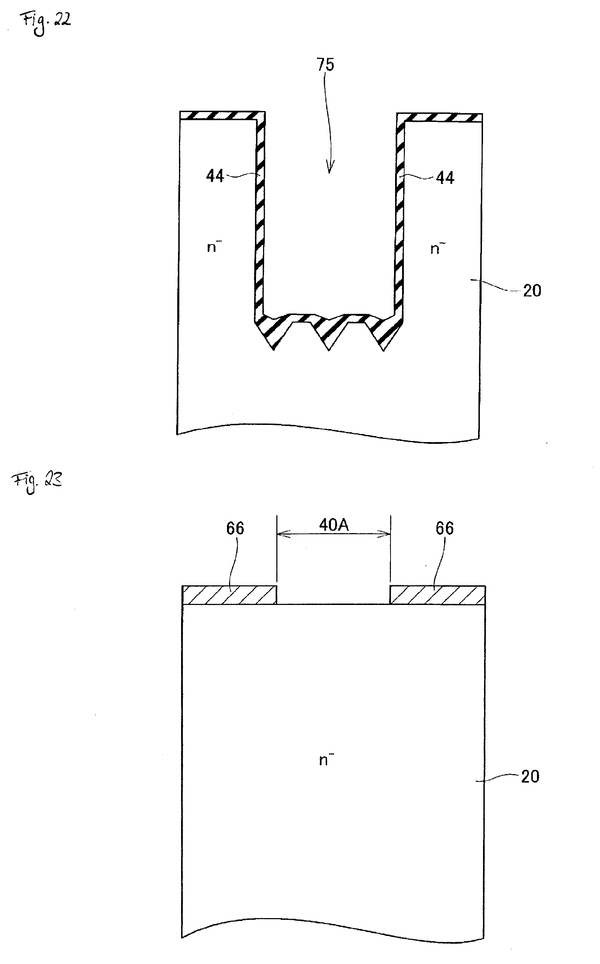

Next, as shown in FIG.22, a thermally oxidized film 44 (which later becomes gate insulating layer 44) is formed at the inner wall of the trench 75. In this thermal oxidation, the projecting trench 75a at the bottom surface of the trench 75 is substantially filled with the thermally oxidized film 44. After these steps, the projecting portion described in this specification can be obtained.

### (The third manufacturing method of the trench gate)

The third manufacturing method of the trench gate 40 will be described with reference to FIGS.23-26.
First, as shown in FIG.23, a mask 66 is patterned on the surface of the semiconductor substrate 20. The opening of the mask 65 is formed to correspond to the trench forming region 40A of the semiconductor substrate 20. Next, the surface of the semiconductor substrate 20 which is exposed from the opening of the mask 66 is etched to form a trench 76 by dry etching technique. In this dry etching, HBr gas is used as the etching gas. This dry etching is operated under the condition that the volatile compound (SiBr₄), produced during the dry etching, in which the semiconductor substrate 20 and the etching gas (HBr) are combined, does not deposit on the bottom surface of the trench 76. Note that as referred to with reference number 82, a part of the volatile compound may deposit on the side surface of the trench 76.

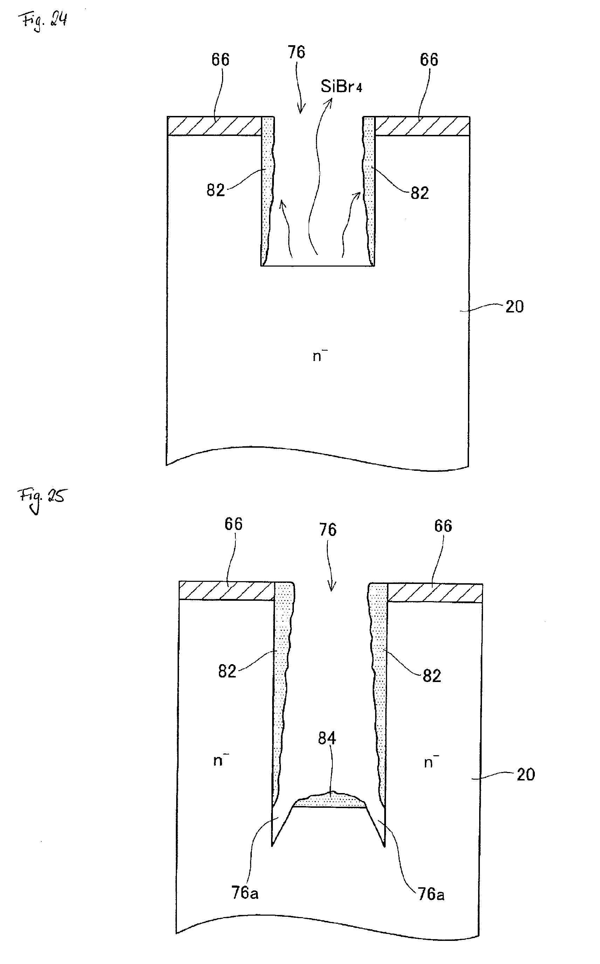

Next, the condition of the dry etching is changed. This dry etching is operated under the condition that the volatile compound (SiBr₄), produced during the dry etching, in which the semiconductor substrate 20 and the etching gas (HBr) are combined, deposits on the bottom surface of the trench 76. In particular, it would be preferable that this step is carried out under the condition of low etching rate. For example, it would be preferable that the etching is carried out at half the speed in comparison with normal etching rate (4000Å/min). As shown in FIG.25, if the volatile compound (SiBr₄) deposits on the bottom surface of the trench 75, much of the volatile compound (SiBr₄) deposits on the center area of the bottom surface of the trench 76 (see reference number 84). Therefore, when the dry etching is continued under the aforesaid condition, the etching at the edge side is faster than the etching at the center area on the bottom surface of the trench 76. As a result, projecting trenches 76a are formed at the edge side of the bottom surface of the trench 76.

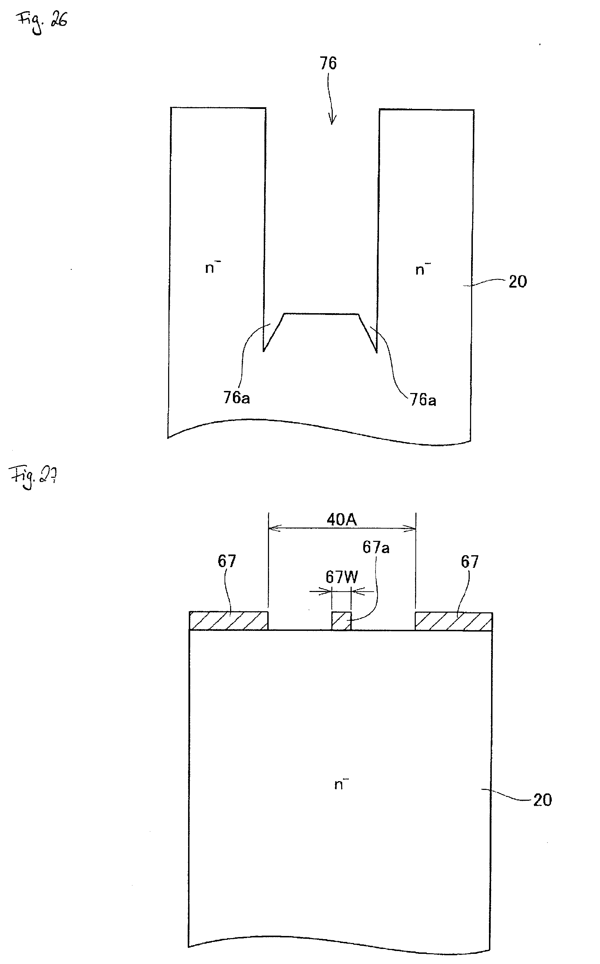

Next, as shown in FIG.26, when removing the deposited volatile compound (SiBr₄), a trench 76 comprising the projecting trenches 76a at edge of the bottom surface is formed. After this, the projecting trenches 76a are filled with the thermally oxidized film by the thermal oxidation technique, so as to obtain the projecting portion disclosed in this specification.

### (The forth manufacturing method of the trench gate)

The forth manufacturing method of the trench gate 40 will be described with reference to FIGS.27-29.
First, as shown in FIG.27, a mask 67 is patterned on the surface of the semiconductor substrate 20. The CVD oxide layer is used for the material of the mask 67. The opening of the mask 67 is formed to correspond to the trench forming region 40A of the semiconductor substrate 20. Further, as shown in FIG.27, a part 67a of the mask 67 (hereinafter sacrifice mask) is also formed on the surface of the trench forming region 40A of the semiconductor substrate 20. The width 67W of the sacrifice mask 67a is very narrow. Note that the sacrifice mask 67a is formed as a part of the mask 67 in this embodiment. However, alternately, the sacrifice mask 67a can be formed with material different from the mask 67.

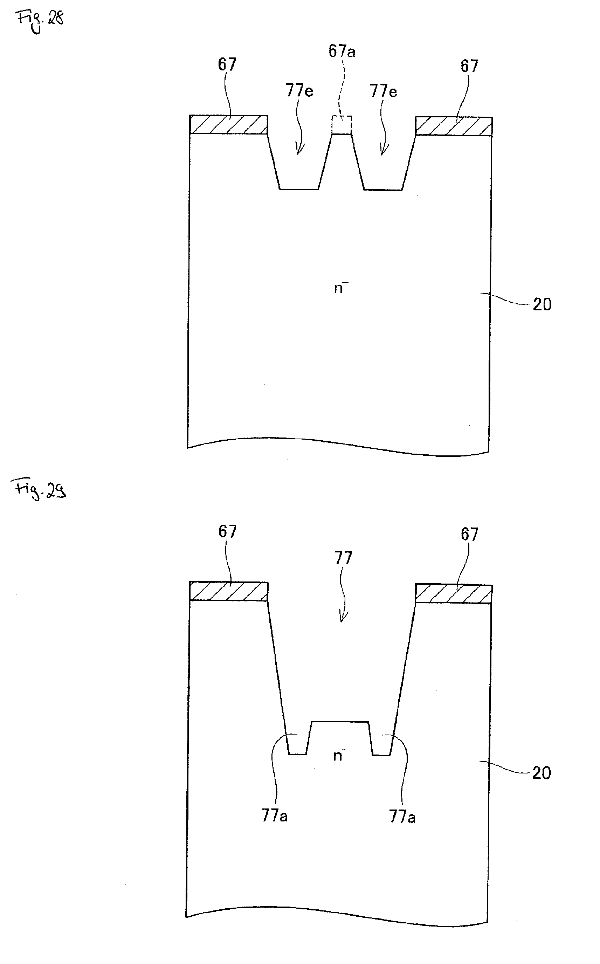

Next, as shown in FIG.28, the surface of the semiconductor substrate 20 which is exposed from the opening of the mask 67 is etched to form an initial trench 77e by dry etching technique. In this dry etching, HBr gas is used as the etching gas. Although the etching rate of the sacrifice mask 67a is slow, the sacrifice mask 67a is gradually etched by the dry etching. Depending on the etching selectivity of the sacrifice mask 67a, the width 67W is adjusted such that the sacrifice mask 67a disappears before the initial trench 77e reaches the eventual depth corresponding to the final trench. In particular, if a loss volume of layer of the sacrifice mask 67a until the initial trench 77e reaches the eventual depth corresponding to the final trench is assumed as "x", the width 67W of the sacrifice mask 67a is adjusted to be smaller than "2x". The loss volume of layer "x" is an amount that is etched off from the sacrifice mask 67a at one side surface. Therefore, when the width 67W of the sacrifice mask 67a is adjusted to be smaller than "2x", the sacrifice mask 67a will disappear before the initial trench 77e reaches the eventual depth corresponding to the final trench. A difference of a degree of progress of the etching at the trench forming region 40A is imparted by forming the sacrifice mask 67a at the surface of the trench forming region 40A.

The dry etching continues even after the sacrifice mask 67a disappears. As a result, as shown in FIG.29, the wall between the initial trenches 77e is also etched; and a trench 77 comprising a projecting trench 77a at the bottom surface is formed. After this, the projecting trenches 77a are filled with the thermally oxidized film by the thermal oxidation technique, and the projecting portion disclosed in this specification is thereby obtained.

### (Modified embodiment of the forth manufacturing method of the trench gate)

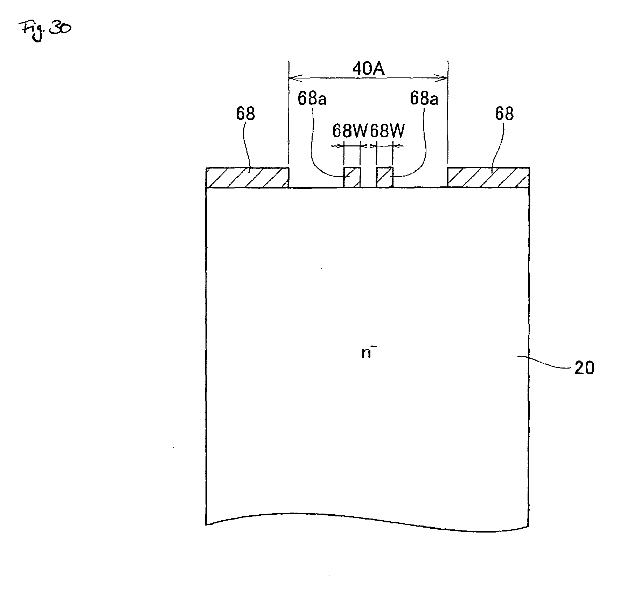

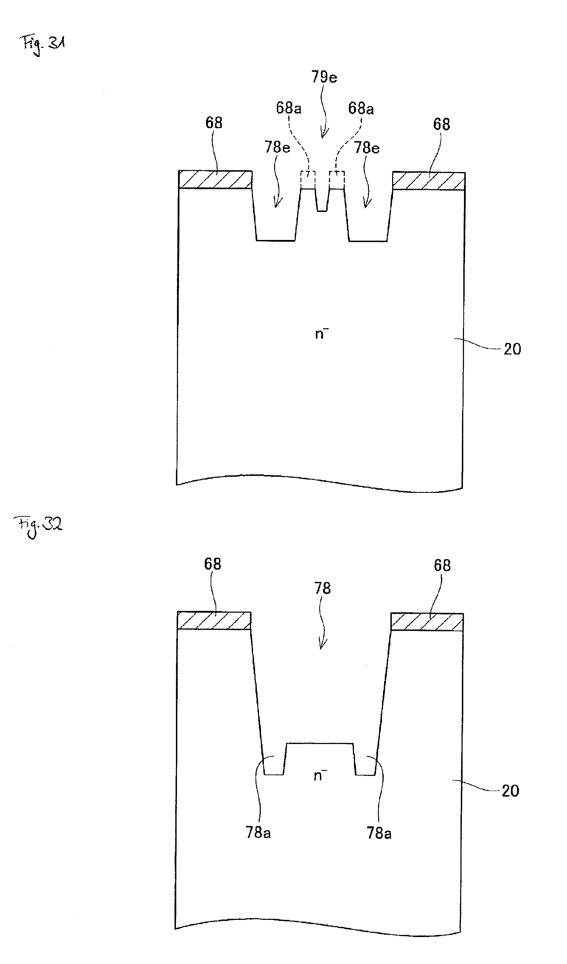

As shown in FIG.30, a plurality of sacrifice masks 68a may be formed on the surface of the trench forming region 40A of the semiconductor substrate 20. In this case, as shown in FIG.31, the width 68W of each sacrifice mask 68a is very narrow. Therefore, when the dry etching is carried out, sacrifice masks 68a disappear when initial trenches 78e, 79e reach the certain depth. When the dry etching continues even after the sacrifice masks 68a disappear, as shown in FIG.32, a trench 78 comprising a projecting trench 78a at the bottom surface is formed. After this, the projecting trench 78a is filled with the thermally oxidized film by the thermal oxidation technique so as to obtain the projecting portion disclosed in this specification.

As mentioned above, the plurality of sacrifice masks 68a is disposed in the distributed pattern so that the wider trench 78 can be formed.
Also, in this embodiment, since the distance between sacrifice masks 68a is narrow, the depth of the initial trench formed therebetween is shallow. Therefore, the configuration of the initial trench 79e disappears in the final trench 78 by the dry etching. However, when the distance between sacrifice masks 68a is longer, the initial trench 79e is deeply formed, and the configuration of the initial trench 79e appear at the bottom surface of the final trench 78. In this case, equal to or more than three projecting trenches are formed at the bottom surface of the final trench 78. In the case that such configuration is needed, it is possible realize such configuration by designing the pattern of sacrifice masks 68a.

Specific embodiments of the present teachings are described above, but these merely illustrate some possibilities of the teachings and do not restrict the scope of the claims. The art set forth in the claims includes variations and modifications of the specific examples set forth above.
Further, the technical elements disclosed in the specification or the drawings may be utilized separately or in all types of combinations, and are not limited to the combinations set forth in the claims at the time of filing of the application. Furthermore, the technology illustrated in the present specification or the drawings may simultaneously achieve a plurality of objects, and has technological utility by achieving one of those objects.

## Claims

1. A semiconductor device comprising:
a surface semiconductor region of a first conductive type;
a deep semiconductor region of the first conductive type;
an intermediate semiconductor region of a second conductive type, wherein the intermediate semiconductor region is disposed between the surface semiconductor region and the deep semiconductor region;
a trench gate extending in the intermediate semiconductor region from the surface semiconductor region toward the deep semiconductor region, wherein the trench gate includes a gate insulating layer and a gate electrode surrounded with the gate insulating layer; and
a projecting portion of an insulating material, wherein the projecting portion is in contact with a surface of the trench gate,
wherein at least a part of the projecting portion projects within the deep region.

2. The semiconductor device according to claim 1, wherein
the gate insulating layer of the trench gate includes a pair of side walls and a bottom wall, wherein each of the side walls is spreading from the surface semiconductor region toward the deep semiconductor region and opposes each other, and the bottom wall is spreading from one of the side walls to another of the side walls, and
the projecting portion is in contact with the bottom wall of the gate insulating layer.

3. The semiconductor device according to claim 2, wherein
a plurality of projecting portions is in contact with the bottom wall of the gate insulating layer.

4. The semiconductor device according to claim 3, further comprising:
a bottom wall semiconductor region of the second conductive type, wherein the bottom wall semiconductor region is disposed between the projecting portions being in contact with the bottom wall of the gate insulating layer,
wherein the bottom wall semiconductor region is electrically floating.

5. A method of manufacturing a trench gate, the method comprising:
a first step of forming a first trench with a first depth in a part of a surface of a semiconductor substrate within a trench gate forming region by dry etching; and
a second step of forming a second trench with a second depth in a remaining portion of the surface of the semiconductor substrate within the trench gate forming region by dry etching,
wherein the first depth is deeper than the second depth.

6. The method of manufacturing the trench gate according to claim 5, wherein
in the first step, the first trench is formed at least in a part of an area along a peripheral of the trench gate forming region.

7. A method of manufacturing a trench gate, the method comprising:
a first step of forming a plurality of trenches in a part of a surface of a semiconductor substrate within a trench gate forming region by dry etching; and
a second step of providing etchant into the plurality of trenches and forming a projecting trench projecting downwardly from a bottom surface of the trench by wet etching,
wherein a side surface of the trench formed by the first step has a first plane direction,
a side surface of the projecting trench formed by the second step has a second plane direction, and
the first plane direction and the second plane direction are non-parallel.

8. The method of manufacturing the trench gate according to claim 7, wherein
the semiconductor substrate is a silicon substrate,
the first plane direction is (100), and
the second plane direction is (111).

9. A method of manufacturing a trench gate, the method comprising:
a first step of forming a trench in a surface of a semiconductor substrate within a trench gate forming region by dry etching; and
a second step of deepening the trench by dry etching under a condition that a volatile compound, produced during the dry etching, in which the semiconductor substrate and an etching gas are combined, deposits on a bottom surface of the trench.

10. A method of manufacturing a trench gate, the method comprising:
a first step of forming a mask on a part of a surface of a semiconductor substrate within a trench gate forming region; and
a second step of forming a trench in the surface of the semiconductor substrate within the trench gate forming region by dry etching,
wherein, in the second step, the dry etching is continued even after the mask on the surface of the trench gate forming region has disappeared.

11. The method of manufacturing the trench gate according to claim 10, wherein,
in the first step, a plurality of masks is dispersed on the surface in the trench gate forming region.

12. A method of manufacturing a semiconductor device, the method comprising:
the method of manufacturing the trench gate described in any one of claims 5 to 11.
